# EUROPÄISCHE PATENTANMELDUNG

(11) **EP 2 280 420 A2**
(43) Veröffentlichungstag der Anmeldung: **02.02.2011**
(21) Anmeldenummer: 10007820.3
(22) Anmeldetag: 28.07.2010
(51) Int. Cl.: H01L 31/048, H01L 31/18

(54) **Photovoltaikmodul mit verbesserter Korrosionsbeständigkeit und Verfahren zu dessen Herstellung**

(30) Priorität: 30.07.2009 DE 102009028118
(71) Anmelder: SCHOTT AG, 55122 Mainz (DE)
(72) Erfinder: Sögding, Thorsten, Dr., 76829 Landau (DE); Dahlmann, Ulf, Dr., 55239 Gau-Odernheim (DE); Eiden, Ralf, Dr., 55122 Mainz (DE); Nattermann, Kurt, Dr., 55347 Ockenheim (DE); Schwirtlich, Ingo, Dr., 63897 Miltenberg (DE); Fliedner, Uwe, 63801 Kleinostheim (DE); Heyer, Fritz, 63755 Alzenau (DE); Güldner, Ralf, 63739 Aschaffenburg (DE)
(74) Vertreter: Fuchs

(57) **Zusammenfassung**

Die vorliegende Erfindung betrifft verbesserte Photovoltaik-Module, die neben metallischem Silicium, welches als Solarzelle in mindestens ein Einbettungsmaterial eingebettet ist, ferner einen Korrosionsinhibitor umfasst. Der Korrosionsinhibitor ist vorzugsweise eine organische Verbindung, weiter bevorzugt enthaltend mindestens 1 Stickstoffatom.

Die erfindungsgemäßen Photovoltaik-Module zeichnen sich durch eine verlängerte Lebensdauer aus, da dieses korrosiven Einflüssen standhält.

## Beschreibung

### Einleitung

Die vorliegende Erfindung betrifft Photovoltaikmodule mit verbesserter Korrosionsbeständigkeit, die metallisches Silicium und mindestens ein Einbettungsmaterial umfassen sowie ein Verfahren zu deren Herstellung.

Die Entwicklung von Photovoltaikmodulen (Photovoltaikmodule) wird bereits seit einigen Jahren stark vorangetrieben. Inzwischen sind verschiedene Produkte mit unterschiedlichen Merkmalen und Materialien auf dem Markt erhältlich. Allen gemeinsam ist die sogenannte Zelle, die im Wesentlichen aus metallischem Silicium besteht. Die Zelle wird zum Schutz vor äußeren Einflüssen mit einer Einkapselung umgeben. Unter der Einkapselung werden alle Materialien verstanden, welche die Solarzelle umgeben. Darunter sind üblicherweise eine Frontscheibe und ein rückseitiger Abschluss, beispielsweise in Form einer Rückscheibe oder einer Rückseitenfolie, sowie das sogenannte Einbettungsmaterial. Das Einbettungsmaterial ist üblicherweise eine Kunststofffolie, insbesondere aus Ethylenvinylacetat (EVA); die Solarzellen können aber auch in anderen transparenten Materialien einlaminiert oder eingegossen sein.

Es hat sich herausgestellt, dass verschiedene Einbettungsmaterialien, und insbesondere EVA, durch UV-Bestrahlung, Luftfeuchte aus der Umgebung oder Temperatureinwirkung degradieren, wobei Abbauprodukte entstehen können, die zum Teil korrosive Eigenschaften aufweisen. Diese Substanzen können sich durch Diffusion im gesamten Photovoltaikmodul bewegen und richten über lange Zeiträume Schäden an metallischen Bauteilen des Photovoltaikmoduls an. Zu den metallischen Bauteilen gehören insbesondere die sogenannten Verbinder aber auch die Metallisierung und alle weiteren Bauteile aus Metall. Die chemische Korrosion an den metallischen Bauteilen führt letztendlich zu einer Leistungsabnahme im Modul während des Betriebs, die der Betreiber der Photovoltaikanlage durch sinkenden Ertrag erkennen kann.

### Stand der Technik

Korrosionsphänomene bei Metallen sind seit langer Zeit bekannt. Es wurden viele Anstrengungen unternommen, die Veränderung des metallischen Materials zu verhindern. Dabei kommen beispielsweise folgende Prinzipien zum Einsatz:
- geeignete Werkstoffauswahl,
- günstige konstruktive Maßnahmen,
- Aufbringen von metallischen Schutzüberzügen (z.B. Zink, Nickel oder Chrom),
- Phosphatierung von Metallen,
- Emaillieren und
- elektrochemische Methoden.

Diese Methoden lassen sich für Photovoltaikmodule bedauerlicherweise nur begrenzt umsetzen, da es bei der Konstruktion des Photovoltaikmoduls stark auf die Transparenz und aufeinander abgestimmte Brechwerteigenschaften der verwendeten Materialien ankommt.

Photovoltaikmodule sind zum Gebrauch über einen Jahrzehnte dauernden Zeitraum bestimmt. In dieser Zeit sind sie extremen Schwankungen der Umgebungsbedingungen ausgesetzt.

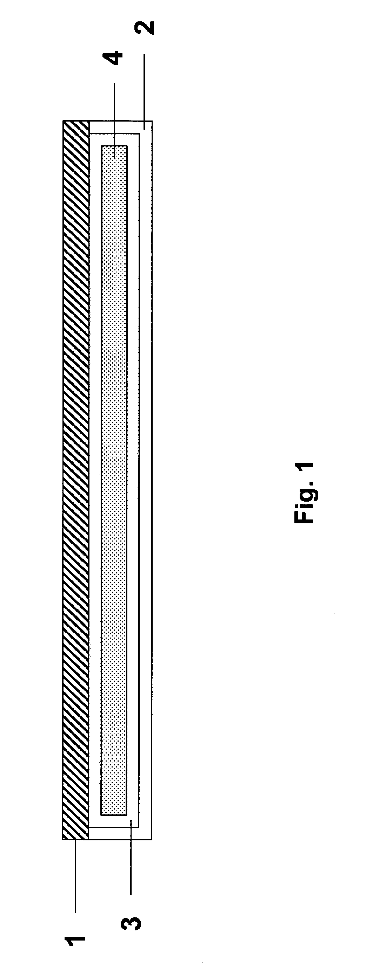

Der beispielhafte, allgemeine Aufbau eines Photovoltaikmoduls wird in Fig. 1 beschrieben:

Die Front 1 eines Photovoltaikmoduls besteht üblicherweise aus Glas, sie wird oft mit einer Einbettungsfolie 3 und der Zelle 4 laminiert. Die Rückseite des Photovoltaikmoduls ist durch einen rückseitigen Abschluss 2 verstärkt. Der rückseitige Abschluss kann ebenfalls eine Glasplatte sein. Denkbar sind auch Rückseitenfolien. Da es bei dem rückseitigen Abschluss nicht auf Transparenz ankommt, ist die Materialauswahl kaum eingeschränkt.

Für die Einbettungsfolie wird häufig EVA (Ethylenvinylacetat) verwendet. Wird die Einbettungsfolie z.B. durch UV-Strahlung, Feuchtigkeit oder Temperatur beansprucht, gibt diese im Laufe der Zeit Spaltprodukte in die umgebenden Schichten ab. Eines dieser Spaltprodukte ist die korrosiv wirkende Essigsäure.

### Aufgabe

Es ist die Aufgabe der vorliegenden Erfindung, ein Photovoltaikmodul bereitzustellen, das den korrosiven Einflüssen, denen das Modul im Laufe seines Einsatzes ausgesetzt ist, standhält.

### Lösung

Die Aufgabe wird durch die Gegenstände der Patentansprüche gelöst.

### Beschreibung

Die Aufgabe wird insbesondere durch ein Photovoltaikmodul gelöst, das metallisches Silicium und mindestens ein Einbettungsmaterial umfasst und das dadurch gekennzeichnet ist, dass das Photovoltaikmodul ferner einen Korrosionsinhibitor umfasst.

"Einbettungsmaterial" im Sinne der vorliegenden Erfindung beschreibt Bauteile des Photovoltaikmoduls, welche die Solarzellen zu deren Schutz umgeben. Die Solarzellen sind mit anderen Worten in dieses Material eingebettet. Insbesondere sind jene Materialien des Photovoltaikmoduls als Einbettungsmaterialien zu verstehen, die in Kontakt zu den Solarzellen des Photovoltaikmoduls stehen. Ein Einbettungsmaterial kann beispielsweise eine Kunststofffolie, insbesondere aus EVA, sein. In Ausführungsformen, in denen die Solarzellen zumindest zu einer Seite nicht von einer Folie eingebettet sind, sondern direkten Kontakt zur Frontscheibe oder zum rückseitigen Abschluss des Moduls haben, stellen diese Komponenten ein Einbettungsmaterial dar.

In besonderen Ausführungsformen der vorliegenden Erfindung wird der Korrosionsinhibitor über das Einbettungsmaterial in das Photovoltaikmodul eingebracht. Zu diesem Zweck wird das Einbettungsmaterial vor Assemblierung der erfindungsgemäßen Photovoltaikmodule mit dem erfindungsgemäßen Korrosionsinhibitor versehen.

Gemäß bevorzugter Ausführungsformen ist der Korrosionsinhibitor ein Gasphaseninhibitor, so dass er sich in bevorzugten Herstellungsverfahren auf die Einbettungsmaterialien aufdampfen lässt. Zu diesem Zweck wird das Einbettungsmaterial zusammen mit dem Korrosionsinhibitor in einen gasdichten Raum eingebracht, der bevorzugt über einen Zeitraum von zwischen 2 und 4 Stunden auf Temperaturen von bevorzugt zwischen 100 und 200°C, weiter bevorzugt 130 und 170°C , erhitzt wird.

Der Korrosionsinhibitor steht dann im Photovoltaikmodul den Solarzellen zur Verfügung, in dem bei Sonneneinstrahlung aufgrund der erhöhten Temperatur eine Verdampfung des Inhibitors stattfindet, der sich sodann auf die kühleren Komponenten des Photovoltaikmoduls, nämlich die Solarzellen aus metallischem Silicium und andere metallische Bauteile, niederlässt.

Der Korrosionsinhibitor adsorbiert an die metallischen Oberflächen. Diese Oberflächen sind auch die besonders korrosionsempfindlichen Teile in den Photovoltaikmodulen, so dass sich die vorteilhafte korrosionseindämmende Wirkung des Inhibitors auf die besonders empfindlichen Stellen konzentriert.

In alternativen Ausführungsformen wird der Korrosionsinhibitor im Herstellungsverfahren direkt auf die Solarzellen aufgebracht. Aufgrund des hier beschriebenen Effektes, des Verdampfens und Adsorbierens an Oberflächen, wird sich durch Wärmeeinwirkung in Folge der Sonneneinstrahlung in jedem der Photovoltaikmodule, gleich nach welchem Herstellungsverfahren es hergestellt ist, dieselbe korrosionsinhibierende Wirkung einstellen.

Bevorzugt ist der Korrosionsinhibitor, der im Einbettungsmaterial des Photovoltaikmoduls integriert ist, ein Gasphaseninhibitor.

Im Gegensatz zu den festen und flüssigen Inhibitoren wirken die gasförmigen Inhibitoren (Gasphaseninhibitor) durch Adsorption an die Metalloberflächen und bewirken somit eine räumliche Trennung zwischen dem aggressiven Medium und Metall bzw. zwischen der Anode und der Kathode. Die Erfinder vermuten, dass durch die starken Temperaturschwankungen, die auf ein Photovoltaikmodul einwirken, feine Risse in den Komponenten der Solarzellen auftreten. Diese Risse bieten einen optimalen Angriffspunkt für korrosionsfördernde Abbauprodukte der Modulkomponenten. Weil diese Risse erst nach der Herstellung des Moduls auftreten, kann ein entsprechender Schutzanstrich nicht für effektiven Korrosionsschutz sorgen.

Ein Gasphaseninhibitor ist **dadurch gekennzeichnet, dass** er sich aus der Gasphase an den zu schützenden Bauteilen abscheidet und so auch kleine Risse abdecken kann. Es kommt im Sinne dieser Erfindung also darauf an, dass der Korrosionsinhibitor im Betrieb des Photovoltaikmoduls in die Gasphase übergehen kann und sich auf den zu schützenden Teilen niederlassen kann. Schließlich sind die angesprochenen Risse bei Herstellung des Moduls noch nicht entstanden, so dass ein Schutzanstrich mit einem festen oder flüssigen Gasphaseninhibitor wenig sinnvoll wäre. Der feste oder flüssige Inhibitor würde nämlich auch im Betrieb an Ort und Stelle verweilen und neu entstandene Risse im Material nicht abdecken können.

Es ist also erforderlich, dass der Gasphaseninhibitor während des Betriebes des Photovoltaikmoduls zumindest bei höheren Betriebstemperaturen, insbesondere bei Sonnenschein, zumindest teilweise in den gasförmigem Zustand übergeht. Dies ist auch deshalb sinnvoll, weil sich die betroffenen Bauteile bei Wärme ausdehnen und so eine gute Angriffsfläche bieten. Natürlich wirken die korrosiven Substanzen im Modul gerade in der Wärme wesentlich aggressiver als in der Kälte.

Der Korrosionsinhibitor zum Einsatz im Photovoltaikmodul gemäß der vorliegenden Erfindung ist bevorzugt eine organische Verbindung. Bevorzugt ist der Korrosionsinhibitor ausgewählt aus Verbindungen mit stickstoffhaltigen Heterozyklen. Besonders bevorzugt ist der Korrosionsinhibitor ausgewählt aus der Gruppe bestehend aus Aminen, Zykloaminen, Zykloaminen mit angehängten Kohlenwasserstoffgruppen, Phenylaminen, Anilin, Anilin mit angehängten Kohlenwasserstoffgruppen, Toluidinen, Toluidinen mit angehängten Kohlenwasserstoffgruppen, Amiden, aromatischen Azolen und Acetylenalkoholen.

Ferner bevorzugt ist der Korrosionsinhibitor ausgewählt aus der Gruppe der Triazole.

Es hat sich gezeigt, dass die genannten Korrosionsinhibitoren besonders geeignet sind, durch Chemisorption, also Absorption an Oberflächen durch Ausbildung einer chemischen Bindung, einzugehen. Am meisten bevorzugt ist der Korrosionsinhibitor ein Benzotriazol oder ein Tolyltriazol. Es hat sich außerdem gezeigt, dass die genannten Inhibitoren die optische Transmission der Einkapselungsmaterialien nicht beeinträchtigen und ferner die Haftung der Einbettungsmaterialien an den nichtmetallischen Komponenten nicht vermindert wird.

Wenn in dieser Beschreibung von "einem Korrosionsinhibitor" die Rede ist, so ist darin auch eine Mischung mehrerer Korrosionsinhibitoren umfasst, sofern auch diese Mischung die erfindungsgemäßen bevorzugten Eigenschaften aufweist. Gleichwohl ist es bevorzugt, dass lediglich ein Korrosionsinhibitor verwendet wird, da sich so dessen Einfluss auf das Photovoltaikmodul besser einschätzen lässt.

Ist in dieser Beschreibung von "einer Solarzelle" die Rede, so umfasst dieser Begriff auch mehrere Solarzellen.

Das Photovoltaikmodul ist so ausgestaltet, dass der Korrosionsinhibitor das Modul nicht verlassen kann und somit während der gesamten Einsatzdauer des Photovoltaikmoduls die Korrosion metallischer Bauteile verhindert.

Die Einbettungsfolie ist bevorzugt ausgewählt aus EVA.

Der das Photovoltaikmodul rückseitig begrenzende rückseitige Abschluss ist bevorzugt aus Glas oder einer Folie gefertigt.

Die Aufgabe dieser Erfindung wird ferner durch ein Verfahren gelöst, das den folgenden Schritt umfasst:
- Einbringen eines Korrosionsinhibitors in ein Photovoltaikmodul.

Der Korrosionsinhibitor, der in dieses Photovoltaikmodul eingebracht wird entspricht bevorzugt dem oben beschriebenen Korrosionsinhibitor. Dieses Verfahren führt daher bevorzugt zu einem Photovoltaikmodul, dass der obenstehenden Beschreibung entspricht.

Die Erfindung betrifft ferner ein Verfahren zur Herstellung eines oben beschriebenen Photovoltaikmoduls, umfassend die folgenden Schritte in beliebiger Reihenfolge:
- Einbringen einer Solarzelle in einen Raum
- Einbringen des Gasphaseninhibitors in diesen Raum.

Bevorzugt umfasst das Verfahren ferner den Schritt
- Erhitzen des Raumes auf eine erhöhte Temperatur zwischen 100 und 200°C, bevorzugt zwischen 130 und 170 °C.

Bevorzugt umfasst das Verfahren ferner den Schritt
- Druckausgleich zwischen dem Inneren des Raumes und der Umgebung.

Bevorzugt umfasst das Verfahren ferner den Schritt
- Halten des Raumes bei der erhöhten Temperatur für eine Zeit von zwischen 2 und 4 Stunden.

Der Raum hat bevorzugt ein Volumen von zwischen 0,5 und 5 m³. Der Gasphaseninhibitor wird bevorzugt in einer Menge von wenigstens 1 kg pro m³ Raumvolumen eingesetzt.

In alternativen Ausführungsformen wird obenstehendes Verfahren nicht auf die Solarzelle sondern auf das Einbettungsmaterial angewandt, so dass der Korrosionsinhibitor über das Einbettungsmaterial in das Photovoltaikmodul gelangt. In bevorzugten Ausführungsformen werden sowohl die Solarzelle als auch die Einbettungsmaterialien auf diese Weise mit einem Korrosionsinhibitor versehen.

In alternativen erfindungsgemäßen Herstellungsverfahren wird der Korrosionsinhibitor in ein Masterbatch eingebettet, das in das Einbettungsmaterial eingeführt wird. Bei der Herstellung des Photovoltaikmoduls wird bevorzugt eine feste Verbindung auf molekularer Ebene zwischen dem Einbettungsmaterial und den metallischen Bauteilen des Moduls hergestellt.

In alternativen erfindungsgemäßen Herstellungsverfahren wird die Solarzelle vor Zusammenbau des Moduls in eine Lösung des Korrosionsinhibitors getaucht. Verfahren, welche die Solarzelle direkt mit dem Korrosionsinhibitor versehen, haben den Vorteil, dass der Korrosionsinhibitor direkt auf einen zu schützenden Bereich aufgetragen wird und somit die Menge des Inhibitors reduziert werden kann. Folglich sind diese Verfahren besonders bevorzugt.

### Beispiel

Dieses Ausführungsbeispiel schränkt den Schutzbereich der Ansprüche nicht ein.

Ausführungsbeispiel für die Beschichtung von Solarzellen mit Korrosionsinhibitor

In ein Gefäß wird eine Menge von Tolyltriazol-Granulat in einer separaten Schale gegeben. Dazu werden bereits verlöteten Zellen (Strings) in den Gasraum des geschlossenen Gefäßes mit eingebracht. Nun wird das Gefäß unter stetigem Druckausgleich auf 140 °C Umgebungstemperatur erhitzt und für 3 Stunden bei dieser Temperatur belassen. Das Tolyltriazol wird nun die Zellen sowie die verbundenen metallischen Komponenten mit dem Korrosionsinhibitor beschichten und vor angreifenden Medien schützen. Nach der Verweildauer wird das Gefäß mit den Strings abgekühlt und die mit Korrosionsinhibitor geschützten Zellen entnommen. Diese werden nun mit Frontglas, Einbettungsmaterialien und Rückseitenfolien laminiert und als Modul elektrisch verschaltet. Der Korrosionsinhibitor kann nun seine Wirksamkeit gegen Korrosionseffekte in diversen Tests (Damp-Heat-Test, Temperatur-Cycle-Test, Kombi-Test) bestätigen.

Das Beispiel beschreibt die Beschichtung von Solarzellen mit dem Korrosionsinhibitor Tolyltriazol im diskontinuierlichen Betrieb: Die mit den Verbindern zu sog. Strings verlöteten Solarzellen werden in einer (gasdicht abschließbaren und) temperaturregelbaren Beschichtungskammer mit ca. 0.5 bis 5 m³ Volumeninhalt in einem Regalsystem so gestapelt, dass alle Strings allseitig der Atmosphäre ausgesetzt sind. Ventilatoren und Luftleitbleche in der Kammer sorgen für eine Zwangskonvektion mit einer möglichst homogenen Anströmung der Zelloberflächen mit der Luft- bzw. Gasatmosphäre. In einem Bedampfungszyklus werden in einem Verdampfer, bei dem es sich um ein beheizbares, offenes Gefäß handeln kann, wenigstens 1 kg Tolyltriazol-Granulat pro m³ Beschichtungskammervolumen gegeben. Der Verdampfer wird dann auf 140 °C aufgeheizt und für 3 h auf dieser Temperatur gehalten. Die Zellen können auch diese Temperatur erreichen, bevorzugt liegt ihre Temperatur aber unter der Verdampfertemperatur. Während dieser Zeit verdampft ein Teil des Inhibitors und erzeugt eine homogene Dampfkonzentration in der Kammer. Ein Teil des Dampfes absorbiert auf den Zelloberflächen und bildet dort vollständig bedeckende, dichte Schichten. Nach der anschließenden Abkühlung auf Raumtemperatur haften diese Schichten ausreichend fest auf den Zelloberflächen, um nachfolgende Prozessschritte der Modulfertigung (Transport, Lagerung, Lamination etc.) zu überstehen.

Im Prinzip kann in der Beschichtungskammer nach der Beschichtung mit dem Korrosionsinhibitor noch eine zusätzliche (dünne) Konservierungsschicht aufgebracht werden, mit der man die Inhibitorschicht vor Abrieb in nachfolgenden (mechanischen) Prozessschritten bzw. vor Auflösung in den Einbettungsfolien bei der Laminierung schützt.

### Bezugszeichenliste

- 1.: Frontscheibe
- 2.: Rückscheibe oder Rückseitenfolie
- 3.: Einbettungsmaterial
- 4.: Solarzelle

## Patentansprüche

1. Photovoltaikmodul umfassend metallisches Silicium und mindestens ein Einbettungsmaterial, **dadurch gekennzeichnet, dass** das Photovoltaikmodul ferner einen Korrosionsinhibitor umfasst.

2. Das Photovoltaikmodul gemäß Anspruch 1, wobei der Korrosionsinhibitor ein Gasphaseninhibitor ist.

3. Das Photovoltaikmodul gemäß einem oder mehreren der vorhergehenden Ansprüche, wobei der Korrosionsinhibitor eine organische Verbindung ist.

4. Das Photovoltaikmodul gemäß einem oder mehreren der vorhergehenden Ansprüche, wobei der Korrosionsinhibitor aus Verbindungen mit stickstoffhaltigen Heterozyklen ausgewählt ist.

5. Das Photovoltaikmodul gemäß einem oder mehreren der vorhergehenden Ansprüche, wobei der Korrosionsinhibitor ein Benzotriazol ist.

6. Photovoltaikmodul gemäß einem oder mehreren der vorhergehenden Ansprüche, wobei der Korrosionsinhibitor ein Tolyltriazol ist.

7. Das Photovoltaikmodul gemäß einem oder mehreren der vorhergehenden Ansprüche, wobei das Einbettungsmaterial eine Kunststofffolie, bevorzugt EVA, ist.

8. Photovoltaikmodul gemäß einem oder mehreren der vorhergehenden Ansprüche, wobei der Korrosionsinhibitor an die Oberflächen des metallischen Siliciums und/oder der übrigen metallischen Bauteile adsorbiert oder absorbiert ist.

9. Verfahren zur Herstellung eines Photovoltaikmoduls umfassend den Schritt:
a. Einbringen eines Korrosionsinhibitors in ein Photovoltaikmodul.

10. Verfahren zur Herstellung eines Photovoltaikmoduls gemäß Anspruch 9, umfassend die Schritte:
a. Einbringen einer Solarzelle in einen Raum
b. Einbringen des Gasphaseninhibitors ausgewählt aus Verbindungen mit stickstoffhaltigen Heterozyklen in diesen Raum
c. Erhitzen des Raumes auf eine erhöhte Temperatur zwischen 100 und 200°C
d. Druckausgleich zwischen dem Inneren des Raumes und der Umgebung
e. Halten der erhöhten Raumtemperatur für eine Zeit von zwischen 2 und 4 Stunden.
